(19) Europäisches Patentamt
European Patent Office
Office européen des brevets

(11) EP 0 493 963 B1

(12) EUROPEAN PATENT SPECIFICATION

(45) Date of publication and mention of the grant of the patent:
**24.05.2000 Bulletin 2000/21**

(51) Int. Cl.[7]: **G03F 1/14**, H01L 21/027

(21) Application number: **91311985.5**

(22) Date of filing: **23.12.1991**

(54) **Patterned mask having a transparent etching stopper layer**
Strukturierte Maske mit transparenter Ätzstopschicht
Masque microstructuré ayant une couche transparente d'arrêt de gravure

(84) Designated Contracting States:
**DE FR GB**

(30) Priority: **28.12.1990 JP 41562390**

(43) Date of publication of application:
**08.07.1992 Bulletin 1992/28**

(73) Proprietor: **FUJITSU LIMITED**
**Kawasaki-shi, Kanagawa 211 (JP)**

(72) Inventors:
- **Hanyu, Isamu,**
**c/o Fujitsu Limited**
**Kawasaki-shi, Kanagawa, 211 (JP)**
- **Nunokawa, Mitsuji,**
**c/o Fujitsu Limited**
**Kawasaki-shi, Kanagawa, 211 (JP)**
- **Asai, Satoru,**
**c/o Fujitsu Limited**
**Kawasaki-shi, Kanagawa, 211 (JP)**

(74) Representative:
**Fane, Christopher Robin King et al**
**Haseltine Lake & Co.,**
**Imperial House,**
**15-19 Kingsway**
**London WC2B 6UD (GB)**

(56) References cited:
**EP-A- 0 383 534** **EP-A- 0 451 307**

- **PATENT ABSTRACTS OF JAPAN vol. 14, no. 263 (E-938)(4206), 7 June 1990; & JP - A - 282661 (FUJITSU) 23.03.1990**
- **PATENT ABSTRACTS OF JAPAN vol. 11, no. 138 (E-503)(2585), 2 June 1987; & JP - A - 61278179 (AGENCY OF IND. SCIENCE AND TECHNOL.) 09.12.1989**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 493 963 B1

## Description

The present invention generally relates to semiconductor devices and more particularly to the fabrication thereof using a phase shift mask having a patterned layer and a transparent layer that acts as an etching stop layer.

Photolithographic patterning is a fundamental process for fabricating semiconductor devices. In the photolithographic patterning process, a mask that carries thereon transparent and opaque device patterns is used for exposing a device pattern on a substrate. Conventionally, the resolution that can be achieved by the photolithographic patterning process has been limited to about 0.7 μm in correspondence to the wavelength of the optical beam that is used for the exposure.

In recently developed very large scale integrated circuits (VLSIs) having a much higher integration density, on the other hand, the technique of submicron patterning is essential for achieving the desired submicron resolution. Such a high integration density contributes to the increased operational speed of the logic devices. In memory devices, the increased integration density leads to increased memory capacity. For example, the current 4M-bit DRAMs require the design rule of 0.8 μm. On the other hand, the so-called 16M-bit DRAMs require the design rule of 0.5 - 0.6 μm. Further, the future 64M-bit DRAMs require the design rule of 0.3 μm.

Currently, intensive efforts are being made to achieve the foregoing submicron patterning while using the conventional photolithographic patterning process. For example, the use of optical systems that have a larger numerical aperture is being studied. By using an optical system having such an increased numerical aperture, one can increase the degree of resolution while using a conventional visible or ultraviolet optical beam. The use of such an optical beam is particularly advantageous from the view point of increasing the throughput of the exposure process. On the other hand, the use of optical systems having increased numerical aperture raises a problem of decreased focal depth and various studies are being made to eliminate the problem.

The use of a so-called phase shift mask provides a preferable solution to the foregoing problems. With a phase shift mask, a transparent, phase shift pattern having a thickness determined by the wavelength of the optical beam, is provided to cancel the diffraction caused by the edge of the opaque device pattern formed on the mask. Generally, such a phase shift pattern is provided along the edge of the opaque pattern as in EP-A-0383534. When fabricating such a phase shift mask, it is necessary to pattern the transparent layer that provides the phase shift pattern while leaving the device pattern intact.

Conventionally, a silicon nitride film has been used as the etching stop layer that prevents further progress of the etching for protecting the device pattern. More specifically, the silicon nitride film is provided to bury the opaque device pattern underneath with a substantially flat upper major surface, and the transparent layer, typically of silicon oxide, is provided on the upper major surface of the silicon nitride layer as the layer that forms the phase shift pattern. The phase shift pattern is thereby formed by etching the transparent layer, with the etching stopping when the upper major surface of the silicon nitride is exposed as a result of the etching.

In the conventional phase shift mask thus fabricated, there exists a problem in that the silicon nitride layer absorbs the optical beam that is used for the exposure.

FIG.1 of the accompanying drawings shows the transmittance of a silicon nitride layer deposited on a silicon oxide substrate. In the currently used optical exposure system, the radiation with the wavelength of 436 nm in correspondence to the g-line of mercury is generally employed. At this wavelength, the silicon nitride layer can provide a transmittance of more than 60 %. On the other hand, in future optical exposure systems, radiation having shorter wavelengths is going to be used. For example, the use of radiation having the wavelength of 365 nm corresponding to the radiation of the i-line of mercury is being studied. Further, the use of radiation having a wavelength of 248 nm from the KrF excimer laser is being studied. As can be seen in FIG.1, the transmittance of the silicon nitride layer for these shorter wavelengths is less than 30 %. This clearly indicates that a phase shift mask that has the silicon nitride etching stop layer cannot be used in the future optical exposure systems.

Accordingly, it is a general object of the present invention to provide a novel and useful method of fabricating a phase shift mask to be used in a method of fabricating a semiconductor device wherein the foregoing problems are eliminated.

More particularly, it is an object of the present invention is to provide such a method wherein there is fabricated a phase shift mask that carries a transparent phase shift pattern on an etching stop layer which is to bury thereunder a device pattern to be exposed on a substrate.

According to the present invention, there is provided a method of fabricating a phase shift mask to be used in a method of fabricating a semiconductor device, said phase shift mask being itself fabricated by the steps of providing a first layer of a material which consists of MgO or $Al_2O_3$-MgO mixed oxide on an optically transparent substrate; depositing a second layer of silicon oxide on said first layer; and patterning said second layer by an etching process to form a phase shift pattern while using the first layer as an etching stopper.

By working according to the present invention, one can secure a sufficient transmittance in the etching stop layer for the optical radiation having the wavelength of about 400 nm or less, while simultaneously guaranteeing a distinct difference in the etching rate between the phase shift pattern and the etching stop layer. Thus, the phase shift pattern can be formed without damaging the underlying device pattern.

Reference will now be made, by way of example, to the accompanying drawings in which:

FIG.1 is a graph showing the optical transmittance of a conventional phase shift mask that uses a silicon nitride etching stop layer;

FIGS.2(A) - 2(E) are diagrams showing the fabrication of a first phase shift mask embodied by the method of the present invention;

FIG.3 is a graph showing the optical transmittance of a phase shift mask obtained by the process of FIGS.2A-2(E) wherein MgO is used for the etching stop layer;

FIG.4 is a graph showing the optical transmittance of a phase shift mask wherein a mixed MgO-$Al_2O_3$ oxide material is used for the etching stop layer;

FIG.5 is a diagram showing a second phase shift mask usable in a method embodying the present invention which is readily capable of repair;

FIGS.6(A) - 7(E) are diagrams showing a process for repairing defects in the phase shift mask of FIG.5;

FIG.7 is a diagram showing a third phase shift mask usable in a method embodying the present invention; and

FIGS.8(A) - 8(C) are diagrams showing a process for repairing defects in the phase shift mask of FIG.8.

FIGS.2(A) - 2(E) show the steps in a process for fabricating a phase shift mask according to a first embodiment of the first present invention.

Referring to FIG.2(A) first, a device pattern 2 of chromium is formed on the upper surface of a transparent substrate 1 of silicon oxide. An etching stop layer 3 to be described later in detail is deposited on the device pattern 2 to bury the same underneath. The layer 3 has a substantially flat upper surface.

In the step of FIG.2(B), a phase shift layer 4 typically of silicon oxide is deposited on the upper surface of the etching stop layer 3, and a photoresist layer (not shown) is applied to the upper surface of the phase shift layer 4 thus formed. The photoresist layer is then patterned to form a photoresist pattern 5 as shown in FIG.2(C).

Next, in the step of FIG.2(D), the phase shift layer 4 is patterned while using the photoresist pattern 5 as an etching mask. After removing the photoresist pattern 5, a mask having a cross section shown in FIG.2(E) is obtained having a phase shift pattern 6 thereon.

In the foregoing process, the thickness t of the phase shift layer 4 is set to satisfy the following relationship

$$t = \lambda/(2n - 1)$$

wherein n represents the refractive index of the layer 4 and $\lambda$ represents the wavelength of the optical radiation that is used for the exposure. As a result, the phase of the optical beam that has passed through the phase shift pattern 6 is inverted by 180 °. Typically, the layer 4 is formed by depositing silicon oxide by a vacuum evaporation deposition or sputtering process.

The etching stop layer 3 is an essential part of the present invention and is preferably formed with a thickness t' that satisfies a relationship

$$t' = \lambda/2n'$$

wherein n' represents the refractive index of the layer 3. When aluminum oxide having a refractive index of 1.68 is used for the layer 3 in combination with the optical radiation from the g-line of mercury, the thickness t' should be set to about $1.3 \times 10^{-7}$m (1300 Å). Preferably, the etching stop layer 3 is deposited by an electron beam source evaporation process while simultaneously irradiating it with an oxygen ion beam. The etching stop layer 3 thus formed should have excellent transparency with respect to the optical beam having the wavelength of 400 nm or less. The transparency with respect to radiation from KrF excimer lasers (248nm) or the mercury i-line (365 nm) is particularly important in view of the optical exposure systems that will be used in the future. Of course, the etching stop layer 3 should have an excellent resistance against the etching that is used at the time of patterning the phase shift layer 4.

In the present invention, the inventors have found that $A1_2O_3$-MgO mixed oxide, satisfies the foregoing requirements. Hereinafter, the result of experiments conducted on the material will be described in detail.

In an experiment, a layer of $A1_2O_3$-MgO mixed oxide was deposited on a silicon oxide substrate, $Al_2O_3$-MgO mixed oxide being used as well as range end member compositions consisting of $A1_2O_3$ and MgO respectively. Hereinafter, the layer thus formed will be referred to as the etching stop layer in relation to the foregoing structure of FIGS.2(A) - 2(E). As already noted, the deposition was made by the electron beam source evaporation process with a substrate temperature of 300 °C while irradiating the oxygen ion beam with an acceleration voltage of 0.6 kV and a current of 100 mA. The pressure in the deposition chamber was set to 5 - 7 x $10^{-3}$ Torr.

For each test specimen thus obtained, the etching rate was measured for the wet etching process and the dry etching process. In this test, specimens as-formed as well as specimens that were annealed at 700 °C and 900 °C were used. The annealing was achieved by heating the specimen using an infrared lamp for about 30 minutes. It should be noted that each specimen has a structure wherein the etching stop layer is deposited on the silicon oxide substrate with the thickness of about 150 nm.

The following TABLE I summarizes the result of the wet etching test conducted for various compositions of etching stop layer. The etching was conducted in a buffered solution of HF that contained 50 % HF and 40 % $NH_4F$ in a ratio of 1 : 10.

TABLE I

| COMPOSITION | ATOMIC RATIO OF Mg AND Al | | ETCH RATE (Å/MIN) | | |
|---|---|---|---|---|---|
| | Mg | Al | no anneal | 700 °C/30 min | 900 °C/30 min |
| 1 | 0 | 100 | 600 | | 20 |
| 2 | 15.9 | 84.1 | >1500 | 1300 | ≈3 |
| 3 | 28.4 | 71.6 | >1500 | 1480 | ≈0 |
| 4 | 31.0 | 69.0 | >1500 | >1500 | 12 |
| 5 | 44.1 | 55.9 | 50 | 13.0 | 28 |
| 6 | 46.5 | 53.5 | 54 | 9.4 | 11 |
| 7 | 100 | 0 | >1500 | | 380 |

As silicon oxide has an etching rate of 1.3 x $10^{-7}$m/min(1300 Å/min) under the etching condition mentioned above, compositions 1, 2, 3, 4 and 7 in the as-deposited state are not suitable for use as an etching stop layer as long as the wet etching process is used. It should be noted that the conventional silicon nitride etching stop layer has the etching rate of 0.02 x 10 m/min (20 Å/min). Only compositions 5 and 6 have an etching rate fairly comparable with the etching rate of conventional silicon nitride. On the other hand, much improved etching rates are obtained when the etching stop layer is annealed at 900 °C for the compositions 1- 6. Although the cause of this difference has not been explored, it is possible that a change in the mineral composition occurs in the etching stop layer including the formation of spinel ($MgAlO_4$) from the as-deposited material. Further, the improved quality of crystal caused by the heat treatment may contribute to the change of the etching rate for the end compositions 1 and 7. When the temperature of annealing is 700 °C, on the other hand, no substantial change in the etching rate was observed for the compositions 1 - 7.

When the dry etching process is employed, on the other hand, it has been confirmed that the etching rate is about 0-0.003 x$10^{-7}$ m/min (0 - 3 Å/min) for all of the compositions of the etching stop layer even in the as-deposited state. The etching was conducted using an etching gas of a mixture of $CHF_3$, $C_2F_6$ and He with flow rates of 10, 15 and 80 SCCM respectively, at the pressure of 1300 mTorr while applying an electric power of 120 watts. It should be noted that silicon oxide has an etching rate of 0.98 x $10^{-7}$ m/min (980 Å/min) under these dry etching conditions. Thus, the foregoing compositions 1 - 7 act as an effective etching stop when the dry etching process is used.

FIG.3 shows the transmittance of the specimen 7 when a magnesium oxide etching stop layer is deposited on the silicon oxide substrate. As can be seen, an optical transmittance exceeding about 80 % is achieved for the optical radiation that has the wavelength of less than 400 nm. Particularly, a conspicuous peak of transmittance is observed at a wavelength slightly smaller than 300 nm.

Further, FIG.4 shows the transmittance of a further specimen that has an etching stop layer in which Mg and A1 are contained in an atomic ratio of 0.49 : 0.51 for both the as-deposited state and the annealed state. As can be seen, this specimen, shows a transmittance close to 90 % even with a wavelength less than 400 nm.

From the foregoing FIGS.3 and 4, it was clearly demonstrated that mixed $Al_2O_3$ oxide material has an excellent transparency for optical radiation of wavelength less than 400 nm and simultaneously has a sufficient resistance against etching, particularly when annealed at a temperature of about 900 °C. Thus, when mixed $Al_2O_3$-MgO oxide material is used for the etching stop layer 3 of the phase shift mask described previously, one can reduce absorption of the optical beam by the mask even in future optical exposure systems that will use KrF excimer laser radiation or i-line radiation of a mercury lamp.

FIG.5 shows a second phase shift mask usable in a method embodying the present invention which is readily capable of repair.

Referring to FIG.5, the second phase shift mask has an etching stop layer 3 provided directly on the upper major surface of the silicon oxide substrate 1, and a chromium device pattern 2 is formed on the upper major surface of the etching stop layer 3. A phase shift pattern 6 is formed by patterning a silicon oxide layer 4 (not shown in FIG.5) selectively with respect to the etching stop layer 3. Similar to the previous embodiment, the etching stop layer 3 is formed of mixed $Al_2O_3$-MgO oxide material in the as-deposited state or after annealing.

In the structure of FIG.5, one can repair the defective phase shift pattern easily.

Referring to FIGS.6(A) - 6(E) showing the typical repairing process, any defective phase shift pattern 6 shown in FIG.6(A) is removed by applying a coating of a photoresist 7 to the structure of FIG.6(A) and patterning the photoresist to form the patterned resist 7 as shown in FIG.6(B). By applying an etching process while using the patterned resist 7 as the mask, one can remove the defective phase shift pattern 6 entirely as shown in FIG.6(C). As the etching stop layer 3 located under the phase shift pattern 6 is substantially immune to the etching, the layer 3 remains intact.

Next, in the step of FIG.6(D), a layer 8 of silicon oxide is deposited with the thickness t that satisfies the thickness of the phase shift pattern described previously ( $t = \lambda/(2n - 1)$ ), the layer 8 on the photoresist 7 being removed by the lift off process as shown in FIG.6(E). As a result a defect-free phase shift pattern 6 is formed in place of the defective phase shift pattern.

FIG.7 shows a third phase shift mask usable in a method embodying the present invention.

In the present embodiment, the etching stop layer 3 is provided directly on the upper major surface of the silicon oxide substrate 1 similarly to the second embodiment, and the phase shift layer 4 of silicon oxide is provided directly on the upper major surface of the etching stop layer 3. Further, the chromium device pattern 2 is provided on the phase shift layer 4. In correspondence to the gap between adjacent device patterns 2, the layer 4 is selectively etched to form a phase shift pattern 6' that acts exactly the same was as the phase shift pattern 6 of the foregoing embodiments. In the present embodiment, the etching forming the pattern 6' stops exactly at the upper major surface of the etching stop layer 3. It should be noted that the etching stop layer 3 of the present embodiment also employs mixed $Al_2O_3$-MgO oxide material and thereby excellent optical transparency for the etching stop layer 3 is guaranteed as well as the excellent selectivity of the etching process.

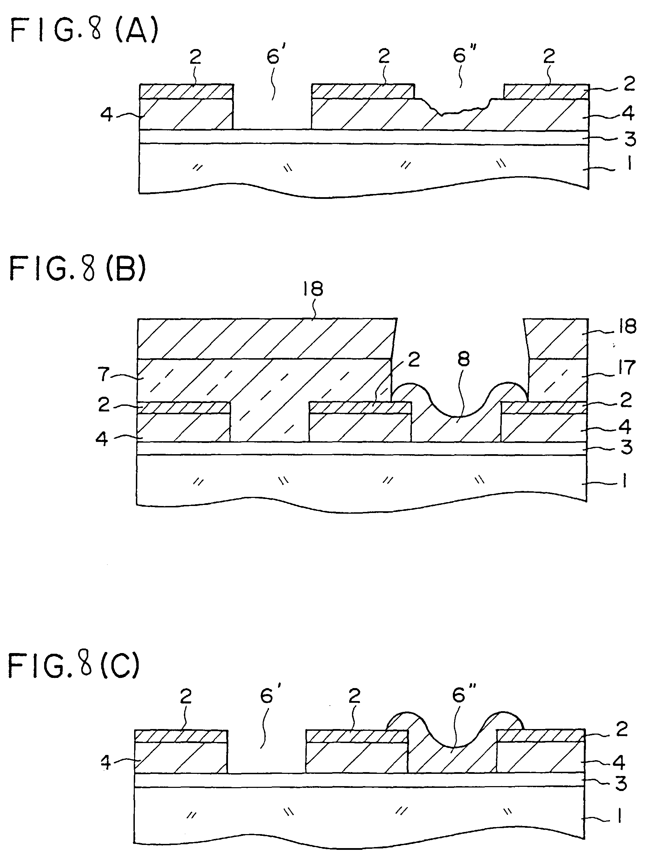

FIGS.8(A) - 8(C) show the steps in a process for repairing a defective phase shift pattern in the third phase shift mask embodying the invention.

Referring to FIG.8(A) there is shown a defective phase shift mask that includes a defective region 6'' on the phase shift layer 4. A photoresist 17 is applied to the structure of FIG.8(A) and patterned to expose the defective region 6'' as shown in FIG.8(B). Because of the excellent selectivity in the etching rate, the etching stop layer 3 remains substantially intact after the defective phase shift pattern is removed by the etching. Further, a phase shift layer 18 of silicon oxide is deposited on the upper surface of the photoresist 17 so that the silicon oxide fills the defective region 6'' as shown in FIG.8(B). After lifting off the silicon oxide layer 18 together with the photoresist 17, one obtains the structure shown in FIG.8(C) wherein the defective region 6'' is repaired.

The phase shift mask of any of the foregoing embodiments uses an etching stop layer 3 that covers the entire surface of the substrate 1. By using mixed $Al_2O_3$-MgO oxide material for the layer 3, one can substantially reduce the optical absorption particularly at wavelengths less than about 400nm. Further, by applying a heat treatment to the mask thus formed, one can achieve a large selectivity in the etching rate with respect to the silicon oxide layer that is used for the phase shift mask.

**Claims**

1. A method of fabricating a phase shift mask to be used in a method of fabricating a semiconductor device, said phase shift mask being fabricated by the steps of providing a first layer (3) of a material which consists of MgO or $Al_2O_3$-MgO mixed oxide on an optically transparent substrate (1);

   depositing a second layer (4) of silicon oxide on said first layer; and
   patterning said second layer by an etching process to form a phase shift pattern (6) while using the first layer as an etching stopper.

2. A method as claimed in claim 1 characterized in that said step of providing the first layer (3) comprises a step of depositing said material on said substrate by an electron beam source evaporation process while irradiating an oxygen ion beam.

3. A method as claimed in claim 2 characterized in that said etching process for patterning the second layer (4) is achieved by a dry etching process.

4. A method as claimed in claim 1 characterized in that said step of providing the first layer (3) comprises a step of depositing said material on the substrate (1), and a step of annealing said first layer at a temperature set such that the first layer is substantially immune to the etching.

5. A method as claimed in claim 4 characterized in that said temperature is set to about 900 °C.

6. A method as claimed in claim 4 characterized in that said etching process for patterning the second layer (4) is achieved by a wet etching process.

7. A method as claimed in claim 1 characterized in that said method further comprises a step of removing the phase shift pattern (6, 6', 6'') selectively with respect to the first layer in correspondence to a defective part of the phase shift pattern and depositing a second phase shift pattern (6, 6', 6'') in correspondence to said defective phase shift pattern.

**Patentansprüche**

1. Verfahren zum Herstellen einer Phasenverschiebungsmaske, die bei einen Verfahren zum Herstellen einer Halbleitervorrichtung zu verwenden ist, welche Phasenverschiebungsmaske durch die folgenden Schritte hergestellt wird:

   Vorsehen einer ersten Schicht (3) aus einem Material, das aus MgO oder $Al_2O_3$-MgO-Mischoxid gebildet ist, auf einem optisch transparenten Substrat (1);
   Abscheiden einer zweiten Schicht (4) aus Siliziumoxid auf der ersten Schicht; und
   Mustern der zweiten Schicht durch einen Ätzprozeß, um ein Phasenverschiebungsmuster (6) zu bilden, während die erste Schicht als Ätzstopper verwendet wird.

2. Verfahren nach Anspruch 1, dadurch gekennzeichnet, daß der Schritt zum Vorsehen der ersten Schicht (3) einen Schritt zum Abscheiden des genannten Materials auf dem Substrat durch einen Elektronenstrahlquellenaufdampfungsprozeß umfaßt, während ein Sauerstoffionenstrahl eingestrahlt wird.

3. Verfahren nach Anspruch 2, dadurch gekennzeichnet, daß der Ätzprozeß zum Mustern der zweiten Schicht (4) durch einen Trockenätzprozeß erreicht wird.

4. Verfahren nach Anspruch 1, dadurch gekennzeichnet, daß der Schritt zum Vorsehen der ersten Schicht (3) einen Schritt zum Abscheiden des genannten Materials auf dem Substrat (1) umfaßt, und einen Schritt zum Annealen der ersten Schicht bei einer Temperatur, die so festgelegt wird, daß die erste Schicht gegenüber dem Ätzen im wesentlichen immun ist.

5. Verfahren nach Anspruch 4, dadurch gekennzeichnet, daß die genannte Temperatur auf etwa 900 °C festgelegt wird.

6. Verfahren nach Anspruch 4, dadurch gekennzeichnet, daß der Ätzprozeß zum Mustern der zweiten Schicht (4) durch einen Naßätzprozeß erreicht wird.

7. Verfahren nach Anspruch 1, dadurch gekennzeichnet, daß das Verfahren ferner einen Schritt umfaßt zum selektiven Entfernen des Phasenverschiebungsmusters (6, 6', 6'') bezüglich der ersten Schicht in Entsprechung zu einem defekten Teil des Phasenverschiebungsmusters und zum Abscheiden eines zweiten Phasenverschiebungsmusters (6, 6', 6'') in Entsprechung zu dem defekten Phasenverschiebungsmuster.

**Revendications**

1. Procédé de fabrication d'un masque à déphasage, destiné à être utilisé dans un procédé de fabrication d'un dispositif à semi-conducteur mettant en oeuvre le masque à déphasage qui est lui-même fabriqué par des étapes comprenant : la disposition d'une première couche (3) d'un matériau constitué de MgO ou d'un mélange d'oxydes $Al_2O_3$-MgO sur un substrat optiquement transparent (1),

le dépôt d'une seconde couche (4) d'oxyde de silicium sur la première couche, et
la mise de la seconde couche sous forme de motifs par une opération d'attaque pour la formation d'un motif de déphasage (6) avec utilisation de la première couche comme couche d'arrêt d'attaque.

**2.** Procédé selon la revendication 1, caractérisé en ce que l'étape de disposition de la première couche (3) comprend une étape de dépôt du matériau sur le substrat par un procédé d'évaporation à l'aide d'une source d'un faisceau d'électrons pendant une irradiation par un faisceau d'ions oxygène.

**3.** Procédé selon la revendication 2, caractérisé en ce que l'opération d'attaque utilisée pour la formation de motifs dans la seconde couche (4) est exécutée par une opération d'attaque à sec.

**4.** Procédé selon la revendication 1, caractérisé en ce que l'étape de disposition de la première couche (3) comprend une étape de dépôt du matériau sur le substrat (1), et une étape de recuit de la première couche à une température réglée afin que la première couche soit pratiquement insensible à l'attaque.

**5.** Procédé selon la revendication 4, caractérisé en ce que la température est réglée aux environs de 900 °C.

**6.** Procédé selon la revendication 4, caractérisé en ce que l'opération d'attaque utilisée pour la formation de motifs dans la seconde couche (4) est réalisée par une opération d'attaque de type humide.

**7.** Procédé selon la revendication 1, caractérisé en ce que le procédé comporte en outre une étape d'enlèvement du motif de déphasage (6, 6', 6'') sélectivement par rapport à la première couche d'une manière correspondant à une partie défectueuse du motif de déphasage, et le dépôt d'un second motif de déphasage (6, 6', 6'') afin qu'il corresponde au motif défectueux de déphasage.

FIG. 1 PRIOR ART

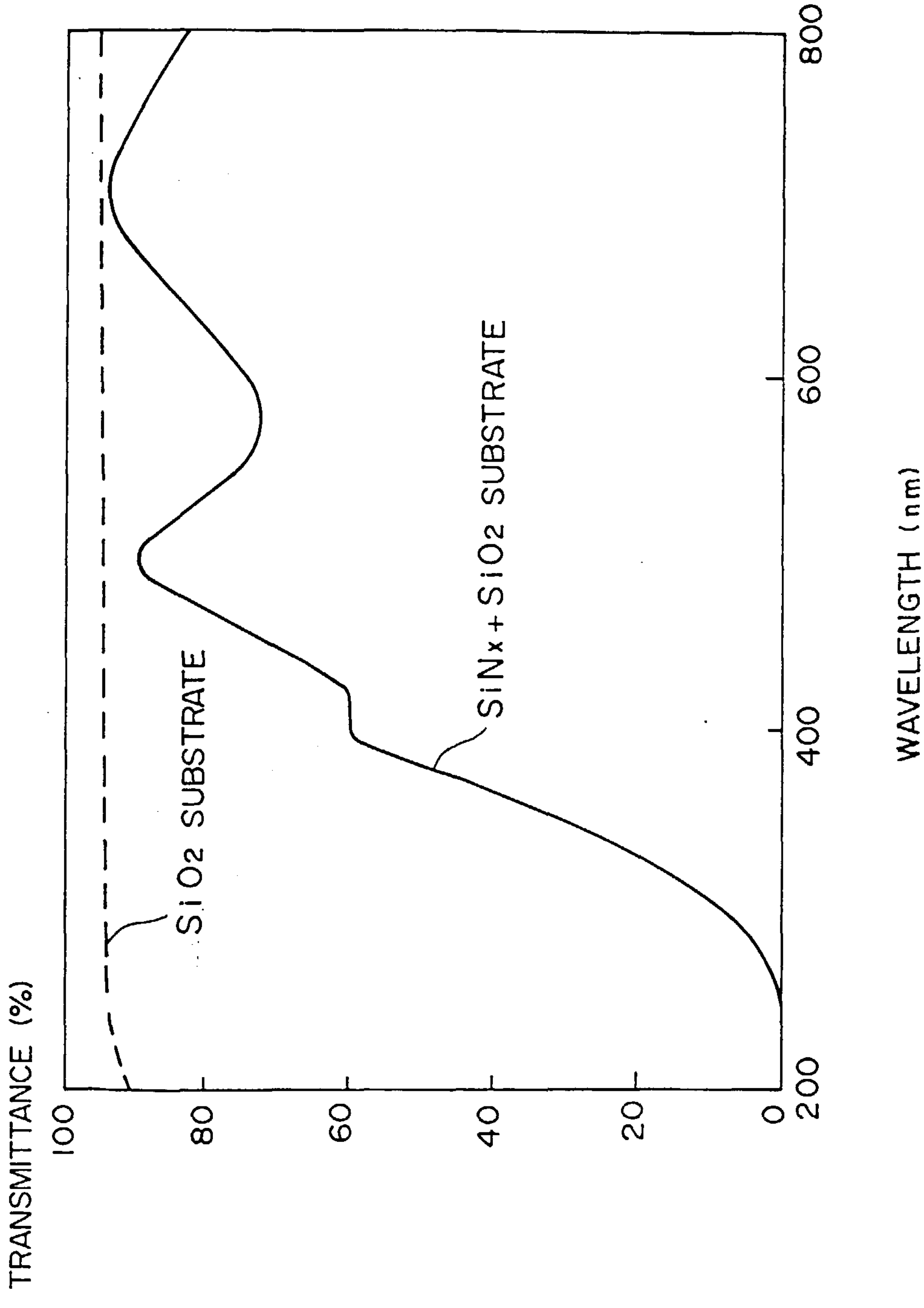

FIG.2(A)

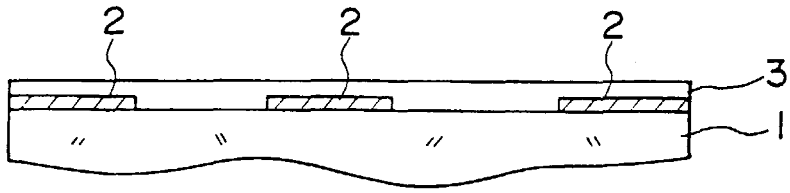


FIG.2(B)

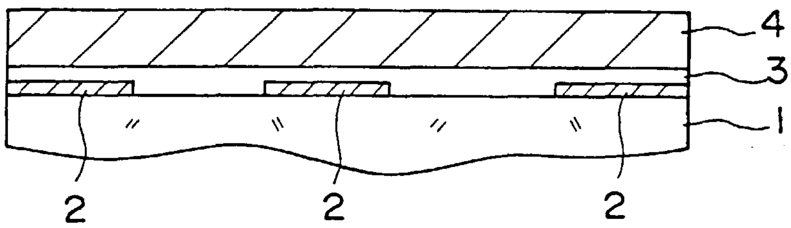


FIG.2(C)

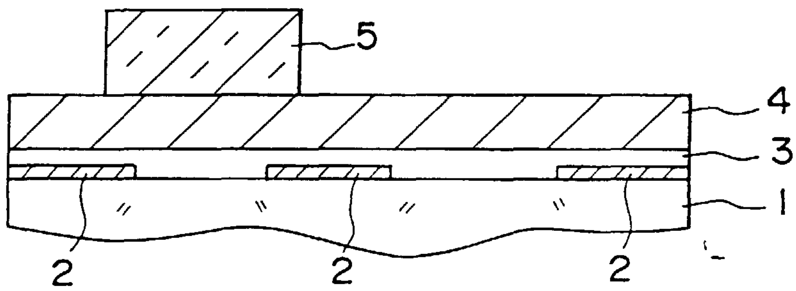


FIG.2(D)

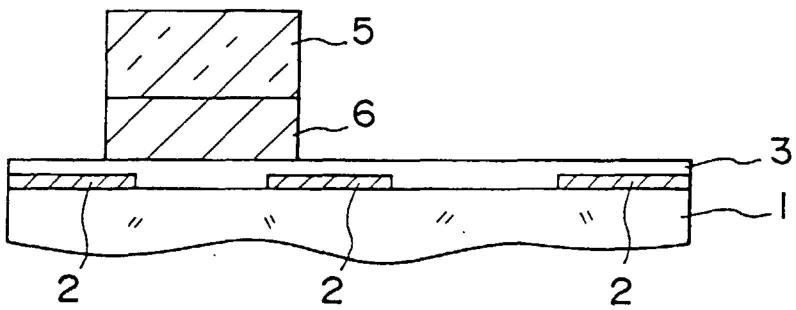


FIG.2(E)

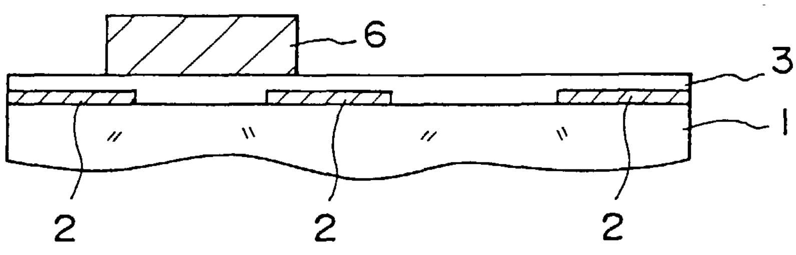

FIG.3

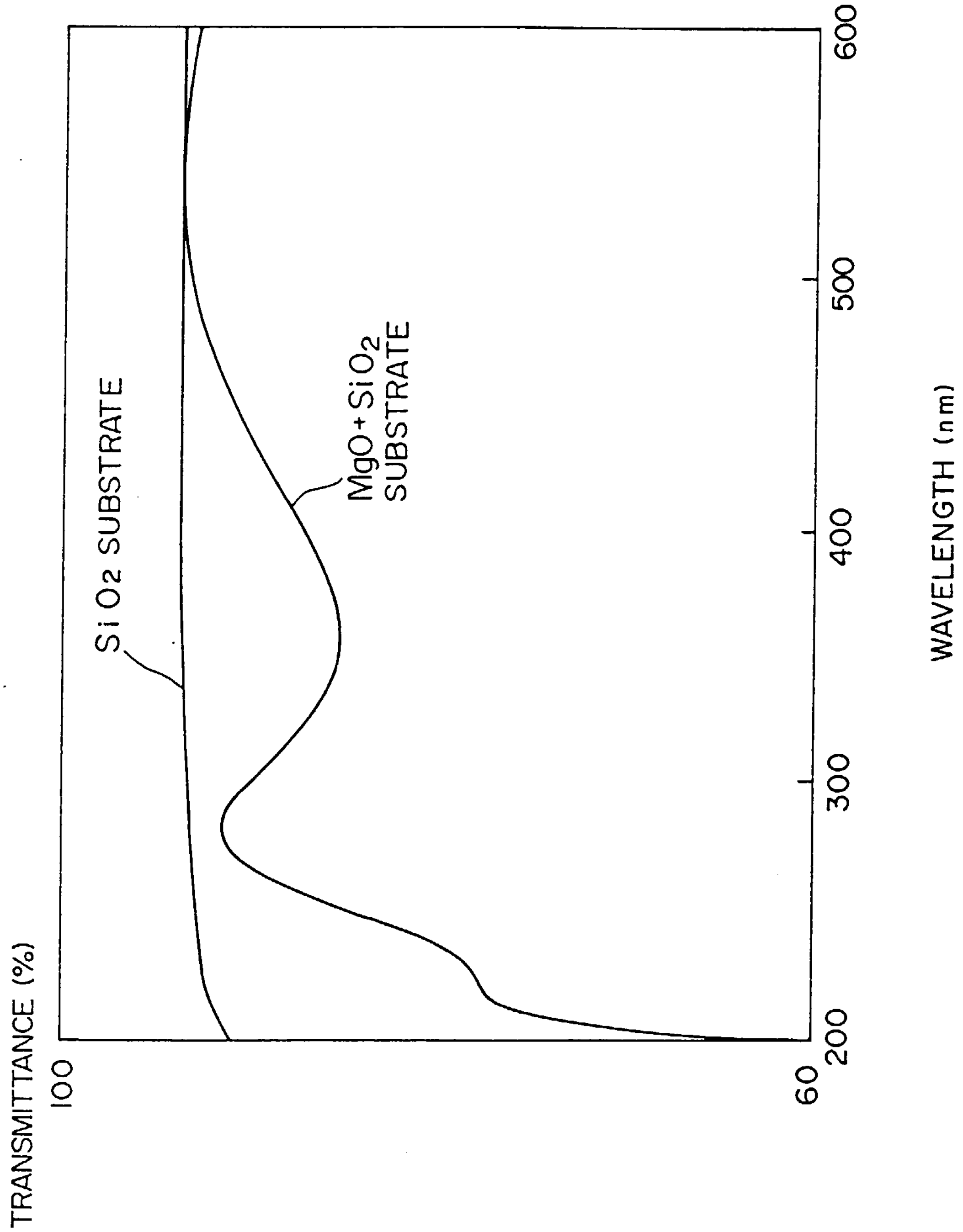
TRANSMITTANCE (%)
100
60
200
300
400
500
600
WAVELENGTH (nm)
Si O2 SUBSTRATE
MgO+SiO2
SUBSTRATE

FIG. 4

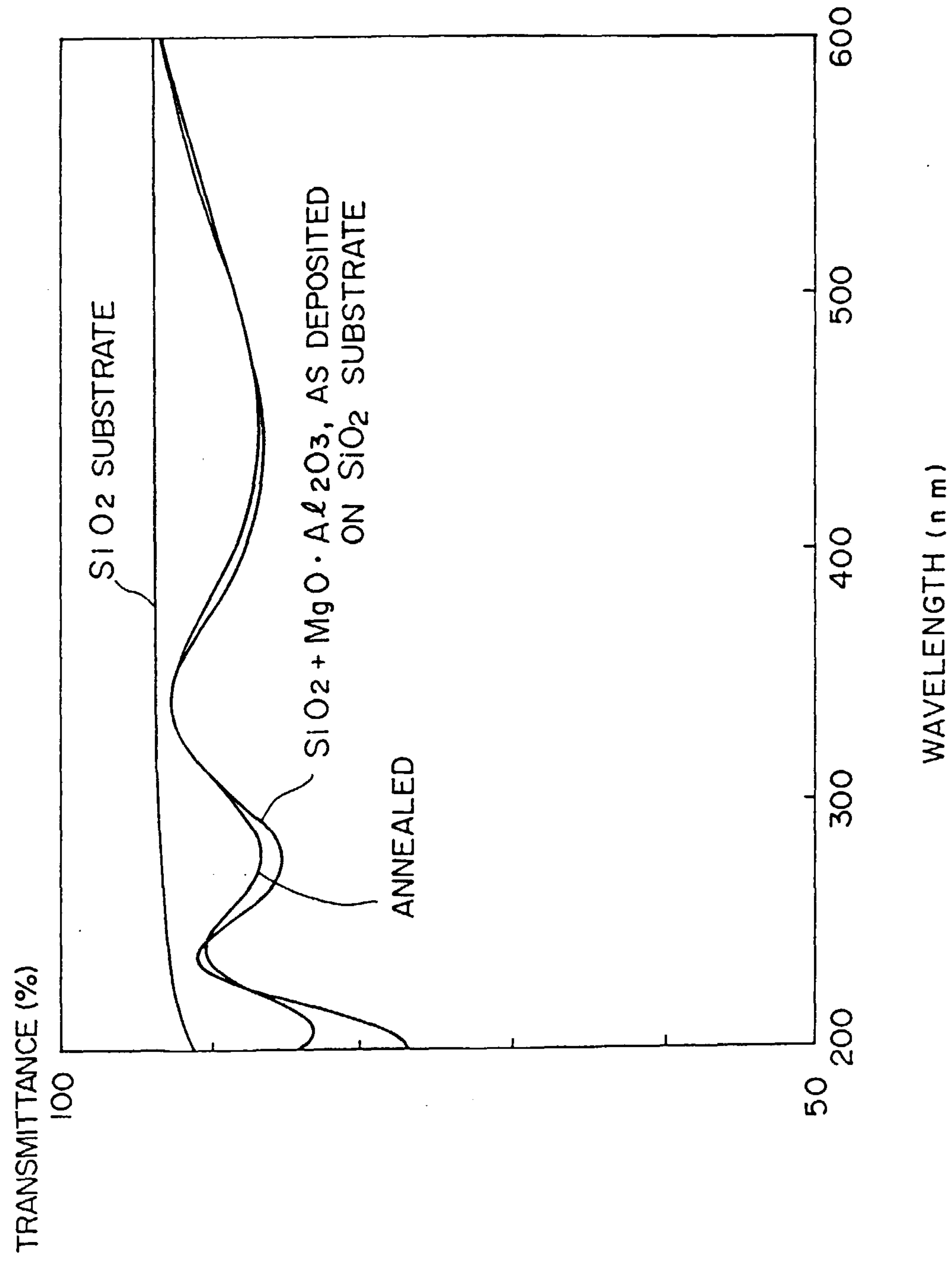
TRANSMITTANCE (%)
100
50
200
300
400
500
600
WAVELENGTH (n m)
$SiO_2$ SUBSTRATE
$SiO_2 + MgO \cdot Al_2O_3$, AS DEPOSITED ON $SiO_2$ SUBSTRATE
ANNEALED

FIG. 5

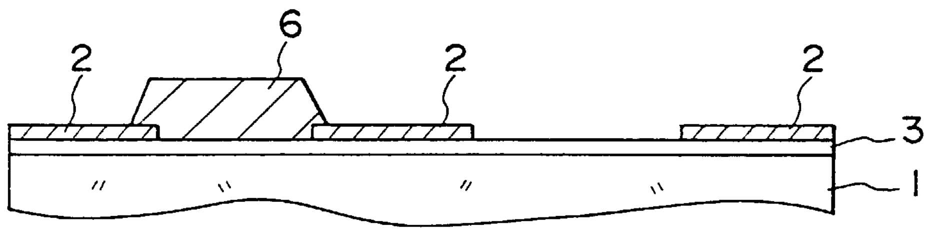

FIG.6(A)

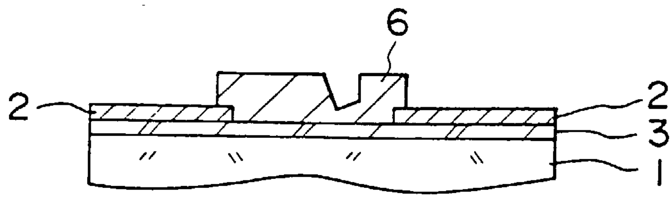


FIG.6(B)

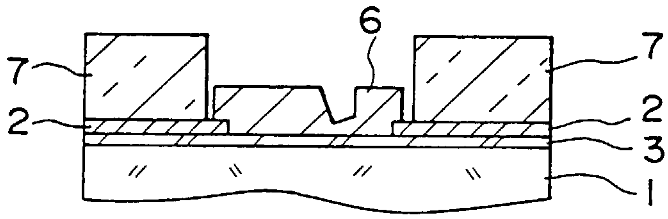


FIG.6(C)

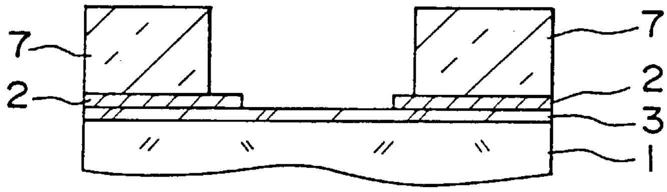


FIG.6(D)

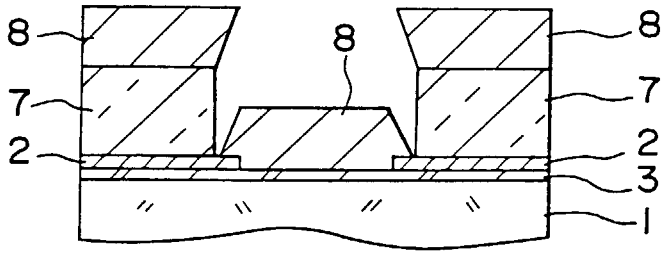


FIG.6(E)

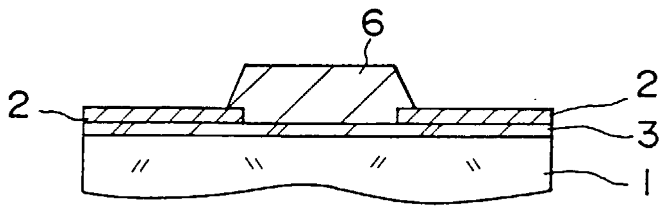

FIG.7

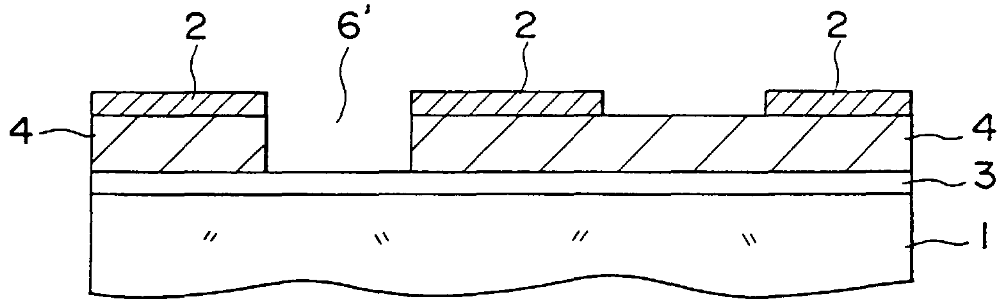

FIG.8 (A)

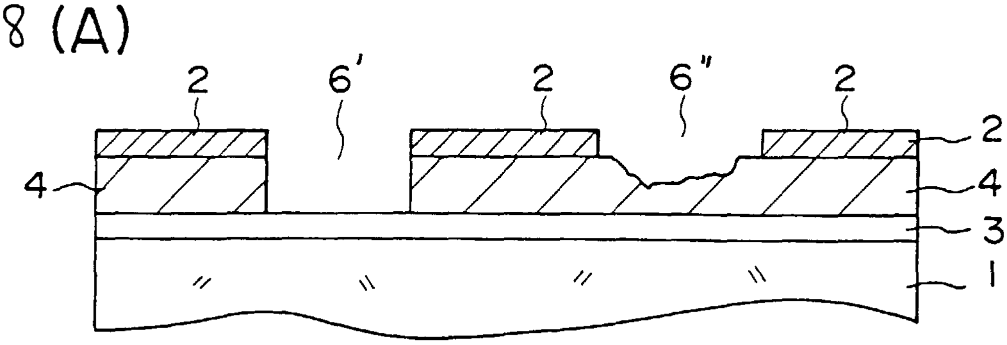


FIG.8 (B)

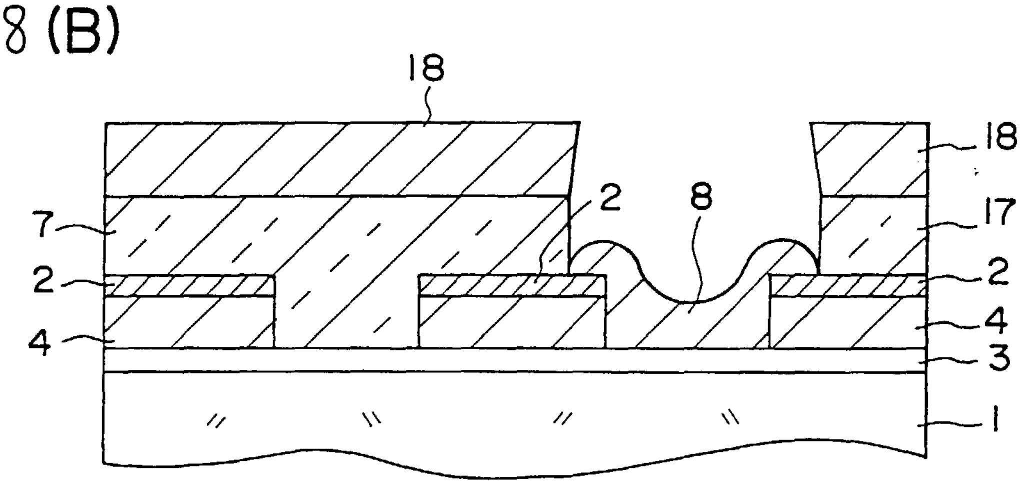


FIG.8 (C)